# EUROPEAN PATENT SPECIFICATION

(11) **EP 1 614 076 B1**
(45) Date of publication and mention of the grant of the patent: **02.11.2006**
(21) Application number: 04726051.8
(22) Date of filing: 06.04.2004
(51) Int. Cl.: G08B 3/10, G11C 7/16, G09B 21/00

(54) **MULTIPURPOSE, RE-RECORDABLE AUDIO MESSAGE DELIVERY SYSTEM**
WIEDERBESCHREIBARES MEHRZWECK-AUDIONACHRICHTENABLIEFERSYSTEM
SYSTEME DE PRODUCTION DE MESSAGES AUDIO REENREGISTRABLES, POLYVALENT

(30) Priority: 14.04.2003 SE 0301091
(43) Date of publication of application: 11.01.2006
(73) Proprietor: Libego AB, 583 30 Linköping (SE)
(72) Inventor: NIEMINEN, Ari, S-591 30 MOTALA (SE); CHRISTIANSEN, Hans Petter, S-583 34 LINKÖPING (SE); TÖRNQVIST, Tomas, S-597 31 ÄTVIDABERG (SE)
(74) Representative: Hammond, Andrew David
(86) International application number: PCT/SE2004/000533
(87) International publication number: WO 2004/090826

(56) References cited:
- WO-A1-00/22591
- WO-A1-01/06980
- WO-A1-90/01759
- US-A- 5 815 586
- US-A- 5 936 515

## Description

### Background

This invention relates to multipurpose, re-recordable audio message delivery system, to be mainly used by blind and visually impaired people, to receive information which otherwise would be in the form of written text. The information can be e.g. medication information on the medicine package, signs in public premises or message written on a "post-it". The invention is also useful to other people who have problems in understanding written text or who are in a situation where reading text is difficult.

One of the big challenges in the society is to reduce the amount of medication errors. One cause of the medication errors is when the user does not see or understand the written prescription information. To solve the problem, several methods or products to give spoken prescription information has been presented.

One method is to label the medication package and to use a separate reader to connect the label identification to separate spoken information, to be produced by the separate reader.

One of the products in this category is Aloud (www.askocorp.com). Another one is Voila Talking label (www.cobolt.co.uk). Aloud can only be used with medication packages, Voila could potentially be used with other packages as well. The problem of these products is usability. It is difficult for a blind or visually impaired people to use two different products at the same time. It is difficult to identify the position of the audio label.

Another method to solve the problem to give spoken prescription information for blind or visually impaired people is to use special "all-in-one" products. In these product the audio message device is attached directly to the medication package and no separate reader is needed. This makes the usability better. However, these products are designed for standard US pillboxes and can thus even not to be used for any type of pillbox, nor to any other product. An example of this category of products is Talking Rx (www.talkingrx.com). Another reference to a similar type of product is presented in US patent US 6,259,794.

Another category of products is the general-purpose audio message delivery products. These can be attached to different type of products, e.g. medication package. However, they are not design for blind and visually impaired. This means, the products include small switches, which make the usage of the product difficult. Also, the products are so designed that they might be difficult for a blind to find. Examples of this types of products is presented e.g. in US patents US 5,387,108, US 5,577,918 and US 5,815,586.

Sometimes the message delivery system is not activated by the blind or visually impaired people themselves. The activation can happen by external means, e.g. a smoke detector can activate a message delivery system to give spoken instructions what to do in a case of emergence. The spoken information could also be useful to ordinary, not disabled, people. An example of a smoke detector with a voice alert is given in the patent WO 90/01759.

### Description of the innovation:

This invention is a multipurpose re-recordable audio message delivery system. The invention is intended to be used by blind and visually impaired people, which have a need to receive information which otherwise would be in the form of written text but can now be delivered as spoken information. The information can be e.g. medication information on the medicine package, signs in public premises or message written on a "post-it". In addition to blind and visually impaired people, the invention is useful to people who have difficulties to read. The invention is also useful for ordinary people in situations were usage of the written text is impractical.

The multipurpose re-recordable audio message delivery system can be used e.g. to
- record, store and playback situation related information, e.g. messages
- record, store and playback information about the product it is attached to or it refers to
- record, store and playback information about the place to which it has been attached
- signal, alarm or notify on a condition encountered

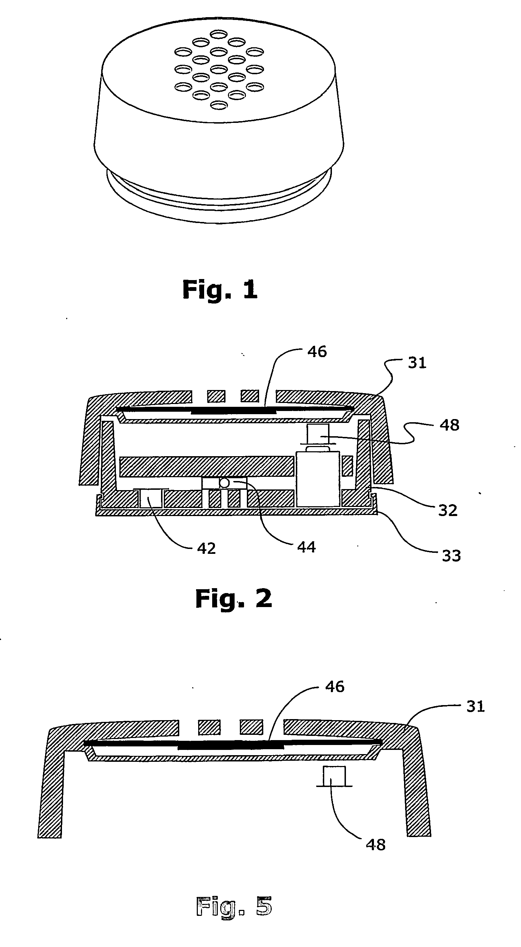

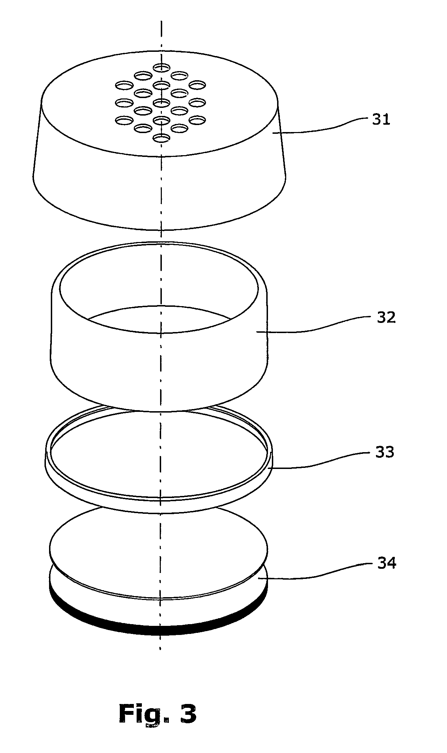

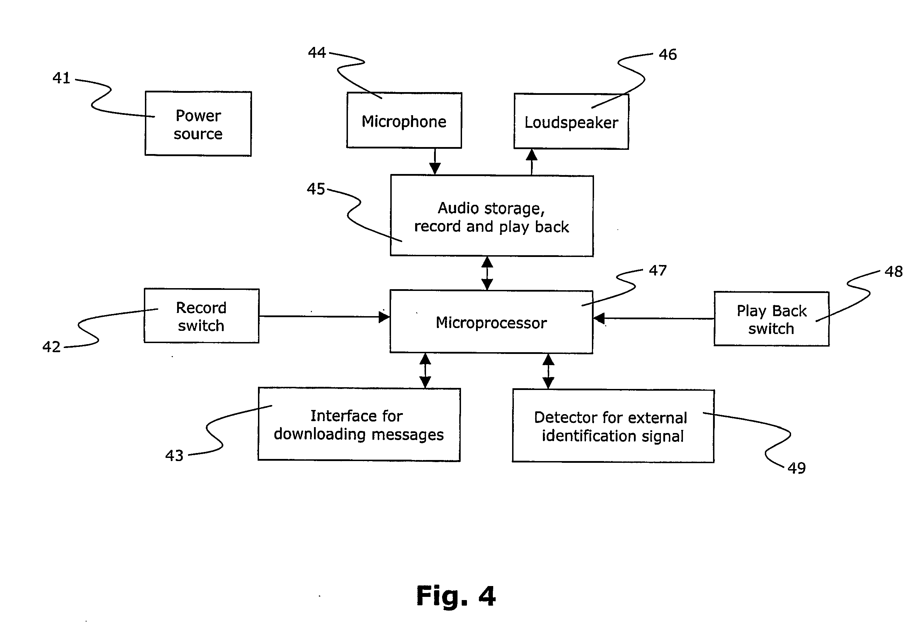

The multipurpose re-recordable audio message delivery system is presented in the Fig. 1, Fig. 2. and Fig. 3, where Fig 1. is the perspective view, Fig. 2. the cross-sectional view and Fig. 3. the exploded view of the multipurpose re-recordable audio message delivery system. It consists of electrical circuit means, housing where the electrical circuit means is built in, and changeable attachments means 33. The housing consists of two parts, a cover 31 and a body 32. The changeable attachments means can include different attachment media 34.
The electrical circuit means Fig 4. is used to record, store, play and re-record the audio message. The message delivery circuitry typically consists of a microphone 44, audio related signal processing 45, a loudspeaker 46, power source 41 and switches or pushbuttons 42, 48. Depending on the complexity of the tasks it does, it can also include a microprocessor 47, additional interfaces 43 or detectors to detect external conditions 49. The additional complexity where only a microprocessor is needed could be e.g. the possibility to sequence through several messages or the possibility to have different messages e.g. during am and pm of a day.

The multipurpose re-recordable audio message delivery system includes a way to record and re-record a message. The user can do this by taking the device to a recording mode by holding the record switch or push-button down 42. Alternatively, the multipurpose re-recordable audio message delivery system can include a way to remotely change the message, e.g. by means of electrical signal through the wires or by means of wireless, e.g. RF-or IR-based, signal. In the case of wireless signaling, special interface needs to be included 43. The need to change or download a message remotely could arise e.g. when the message needs to be adapted to the language of a new listener or when the device is reused and will be e.g. first glued on a medicine package and then glued on another medicine package, containing different types of medicine.

If the multipurpose re-recordable audio message delivery system is to react also to an external signal, e.g. signal on emergency, signal on presence of the a certain people, etc, a way to connect to the external signal needs to be included. The external signal can be e.g. as electrical signal through the wires or wireless, e.g. RF-or IR based, signal. In the case of wireless signaling special detector needs to be included 49. The emergency can be e.g. fire alarm. To detect a presence of a person could be useful in a situation where e.g. a blind approaches the multipurpose re-recordable audio message delivery system and by approaching it he will hear a message. In this case, typically, the blind needs to have a transmitter to indicate his presence. The transmitter can be made using e.g. Bluetooth, RFID, or IR technologies.

The multipurpose re-recordable audio message delivery system could also react to different external signals in a different way, for example playing different messages when different external signals are detected. This function is useful when e.g. blind people speaking one language and other group of blind people speaking second language have different identification signal from each other and the multipurpose re-recordable audio message delivery system can provide a different messages when a member of the first group approaches and when the member of the second group approaches. The messages can be e.g. same information spoken with different languages.

The housing includes two parts body 32 and cover 31. The body part of the housing is used to protect the message delivery circuitry. The cover protects the circuitry as well but is also used as an activator to playback the stored message.

The construction of the housing including the body 32 and the cover 31 is such that in order to activate the playback function through pressing the cover, the housing tolerates, on the other hand, the use of forceful pressing of the cover and, on the other hand, gentle pressing of the cover. This makes the usage of the multipurpose re-recordable audio message delivery system by blind and visually impaired people easier. The cover also provides proper haptical feedback for the user when the cover is pressed.

The cover 31 can also include a special texture, in order to provide information on the usage of the multipurpose re-recordable audio message delivery system. Alternatively, Braille can be used. Colors and symbols could also be useful for people having some visual capabilities left.

The cover 31 can be designed in such a way that it has multifold functionality Fig 5. The cover protects the circuitry build in the audio message device body part of the housing. It also forms the cavity to the loudspeaker 46 attached to it. It also, together with an underlying switch 48, is an actuator of the play function of the multipurpose re-recordable audio message delivery system. This design, with the combined functionality, offers the possibility to optimize reliability of the actuator construction, protection of the circuitry and the quality of the audio message.

The attachment means 33 can be easily snapped on the body part of the housing of the multipurpose re-recordable audio message delivery system. Different attachment means using different attachment media 34 can be designed, e.g. attachment means with adhesive pads an attachment media in order to glue the multipurpose re-recordable audio message delivery system on a flat surface, attachment means using adhesive, deformable polystyrene as attachment media in order to glue the multipurpose re-recordable audio message delivery system on a round surface, e.g. on a bottle, attachment means using magnetic attachment media in order to fix the multipurpose re-recordable audio message delivery system on a magnetic surface, attachment means using needle attachment media in order to fix the multipurpose re-recordable audio message delivery system on a textile. The attachments means make it also possible to reuse the multipurpose re-recordable audio message delivery system, so that e.g. it can be glued on a product, the first attachment means and the product package can be thrown away, and the multipurpose re-recordable audio message delivery system can be glued, using a second attachment means, to a second product.

The attachment means 33 can also be used to protect the parts and functions, which are not used so often. This means that e.g. the record button 42, microphone 44 and battery change mechanism could be hidden between the attachment means 33 and the body of the housing. In addition to the protection against e.g. dirt, it is desirable to cover the record button 42 in order to avoid undesired recording by mistake.

The attachments means 33 can also serve as a "docking station" for the multipurpose re-recordable audio message delivery system. In this case the attachment means is connected to an external device, e.g. a personal computer, and provides proper signals using proper contacts to the multipurpose re-recordable audio message delivery system. This functionality could be needed for example when downloading messages to the multipurpose re-recordable audio message delivery system from a database residing in the personal computer memory. The docking station could also provide means to load the battery of the multipurpose re-recordable audio message delivery system or to provide the supply power to the multipurpose re-recordable audio message delivery system.

The multipurpose re-recordable audio message delivery system is multipurpose and universally applicable. Due to changeable attachment means 33, it can be attached to different object or location and the information can also be situation specific. Due to the different cover designs, the multipurpose re-recordable audio message delivery system appearance can be adapted to different information needs.

The multipurpose re-recordable audio message delivery system is designed for blind and visually impaired people. The whole cover 31 is the activator of the play function; there is no need for a blind or visually impaired people to search for e.g. a certain switch or button. The cover 31 can be pressed using different level of force; it tolerates forceful pressing, but it also functions when gentle press is used. The cover 31 gives haptic feedback, so the user knows that he has found the multipurpose re-recordable audio message delivery system and can press it properly. This design of the whole cover 31 as an activator is useful also for other disabled people, e.g. disabled with motor problems or ataxia.
In the preferred implementation of the multipurpose re-recordable audio message delivery system the loudspeaker 46 is attached on the cover 31 of the housing so that it operates through the top of the housing; the microphone 44, record switch/push-button 42 and battery change mechanism are attached on the body 32 part of the housing so that they are accessible from under the housing; changeable attachment means 33 protects the microphone 44, record switch/push-button 42 and battery change mechanism enclosing around the said elements

## Claims

1. Multipurpose re-recordable audio message delivery system, to record and playback audio information comprising:
a. circuitry to record, store, playback, and re-record audio messages, where the circuitry consists of a microphone (44), audio related signal processing (45), a loudspeaker (46), power source (41), a record switch/push-button (42) and a switch (48);
b. housing consisting of two parts, body (32) and cover (31);
c. the cover (31) part of the housing, together with underlying switch (48), is the actuator of the play function;
d. changeable attachment means (33) to attach the audio device to different objects and surfaces, which changeable attachment means (33) are arranged to be snapped on the body part (32) of the housing, such that the record button 42, microphone 44 and battery change mechanism is hidden between and protected by the attachment means (33) and the body (32) of the housing.

2. The multipurpose re-recordable audio message delivery system, to record and playback audio information as described in the claim 1, wherein said circuitry includes means (43) to download a new message from an external source using electrical, RF- or IR signal.

3. The multipurpose re-recordable audio message delivery system, to record and playback audio information as described in the claim 1, wherein said circuitry includes means (49) to play the message when an external condition is met, the condition can be detected by another device and indicated to the multipurpose re-recordable audio message delivery system by signaling using electrical, RF- or IR signal.

4. The multipurpose re-recordable audio message delivery system, to record and playback audio information as described in the claim 3, wherein said circuitry includes means to respond with a different message to different external conditions.

5. The multipurpose re-recordable audio message delivery system, to record and playback audio information as described in the claim 1, wherein said attachment means (33) can include a functionality which make it possible to use the attachment means (33) as a "docking station" to the multipurpose re-recordable audio message delivery system, providing electrical, RF or IR-connection to an external device and proper signaling to the multipurpose re-recordable audio message delivery system.

6. The multipurpose re-recordable audio message delivery system, to record and playback audio information as described in the claim 1, wherein said cover (31) has the following functions:
a. It protects the circuitry build in the multipurpose re-recordable audio message delivery system body (32) part of the housing;
b. It forms the resounding cavity to the loudspeaker (46) attached to it.

7. The multipurpose re-recordable audio message delivery system, to record and playback audio information as described in the claim 1, wherein
a. loudspeaker (46) is attached on the cover (31) of the housing so that it operates through the top of the housing;
b. the microphone (44), record switch/push-button (42) and/or battery change mechanism are attached on the body (32) part of the housing so that they are accessible from under the housing.

8. The multipurpose re-recordable audio message delivery system, to record and playback audio information as described in the claim 1, wherein pressing the said cover (31) takes the user through a sequence of messages.

9. The multipurpose re-recordable audio message delivery system, to record and playback audio information as described in the claim 1, wherein said circuitry includes a timer to change the delivered message depending the time of the day.

## Patentansprüche

1. Überspielbares Vielzweck-Audioinformationsabgabesystem zur Aufzeichnung und Wiedergabe von Audioinformation, wobei das System folgendes aufweist:
a.) eine Schaltungsanordnung zum Aufzeichnen, Speichern, Wiedergeben und Überspielen von Audioinformationen, wobei die Schaltungen aus einem Mikrophon (44), einer audiogesteuerten Signalverarbeitungseinrichtung (45), einem Lautsprecher (46), einer Energieversorgung (41), einem Aufzeichnungsschalter/Druckknopf (42) und einem Schalter (48) besteht;
b.) ein Gehäuse, das aus zwei Teilen, einem Körper (32) und einer Abdeckung (31), besteht;
c.) wobei die Abdeckung (31) als Teil des Gehäuses gemeinsam mit dem darunterliegenden Schalter (48) der Aktuator für die Abspielfunktion ist;
d.) eine auswechselbare Anbringeinrichtung (33) zum Anbringen der Audiovorrichtung an verschiedenen Objekten und Oberflächen, wobei die auswechselbare Anbringeinrichtung (33) so angeordnet ist, daß sie an dem Körperteil (32) des Gehäuses einschnappbar ist, so daß der Aufzeichnungsknopf (42), das Mikrophon (44) und eine Batteriewechseleinrichtung zwischen der Anbringeinrichtung (33) und dem Körper (32) des Gehäuses verdeckt und von diesen geschützt sind.

2. Überspielbares Vielzweck-Audioinformationsabgabesystem zur Aufzeichnung und Wiedergabe von Audioinformation nach Anspruch 1,
wobei die Schaltungsanordnung eine Einrichtung (43) aufweist, um eine neue Nachricht von einer externen Quelle unter Verwendung eines elektrischen, HF- oder IR-Signals herunterzuladen.

3. Überspielbares Vielzweck-Audioinformationsabgabesystem zur Aufzeichnung und Wiedergabe von Audioinformation nach Anspruch 1,
wobei die Schaltungsanordnung eine Einrichtung (49) aufweist, um die Nachricht abzuspielen, wenn eine externe Bedingung erfüllt ist, wobei die Bedingung von einer anderen Einrichtung detektiert und dem überspielbaren Vielzweck-Audioinformationsabgabesystem durch eine Signalgabe unter Verwendung eines elektrischen, HF- oder IR-Signals angezeigt werden kann.

4. Überspielbares Vielzweck-Audioinformationsabgabesystem zur Aufzeichnung und Wiedergabe von Audioinformation nach Anspruch 3,
wobei die Schaltungsanordnung eine Einrichtung aufweist, um auf unterschiedliche externe Bedingungen mit einer jeweils verschiedenen Nachricht zu reagieren.

5. Überspielbares Vielzweck-Audioinformationsabgabesystem zur Aufzeichnung und Wiedergabe von Audioinformation nach Anspruch 1,
wobei die Anbringeinrichtung (33) eine Funktionalität aufweisen kann, die es möglich macht, die Anbringeinrichtung (33) als eine "Andockstation" an das überspielbare Vielzweck-Audioinformationsabgabesystem zu verwenden, die eine elektrische, HF- oder IR-Verbindung mit einer externen Einrichtung und eine ordnungsgemäße Signalgabe zu dem überspielbaren Vielzweck-Audioinformationsabgabesystem ermöglicht.

6. Überspielbares Vielzweck-Audioinformationsabgabesystem zur Aufzeichnung und Wiedergabe von Audioinformation nach Anspruch 1,
wobei die Abdeckung (31) die folgenden Funktionen hat:
a.) sie schützt die Schaltungsanordnung, die in den Körper (32) als Teil des Gehäuses des überspielbaren Vielzweck-Audioinformationsabgabesystems eingebaut sind;
b.) sie bildet den Schallhohlraum für den daran angebrachten Lautsprecher (46).

7. Überspielbares Vielzweck-Audioinformationsabgabesystem zur Aufzeichnung und Wiedergabe von Audioinformation nach Anspruch 1,
wobei
a.) der Lautsprecher (46) an der Abdeckung (31) des Gehäuses so angebracht ist, daß er durch die Oberseite des Gehäuses wirksam ist;
b.) das Mikrophon (44), der Aufzeichnungsschalter/Druckknopf (42) und/oder die Batteriewechseleinrichtung an dem Körper (32) als Teil des Gehäuses so angebracht sind, daß sie von der Unterseite des Gehäuses zugänglich sind.

8. Überspielbares Vielzweck-Audioinformationsabgabesystem zur Aufzeichnung und Wiedergabe von Audioinformation nach Anspruch 1,
wobei das Aufbringen von Druck auf die Abdeckung (31) den Benutzer durch eine Folge von Nachrichten führt.

9. Überspielbares Vielzweck-Audioinformationsabgabesystem zur Aufzeichnung und Wiedergabe von Audioinformation nach Anspruch 1,
wobei die Schaltungsanordnung einen Zeitgeber aufweist, um die abgegebene Nachricht in Abhängigkeit von der Tageszeit zu ändern.

## Revendications

1. Système de production de messages audio réenregistrables, polyvalent, pour enregistrer et lire les informations audio comportant :
a. un circuit pour enregistrer, mémoriser, lire, et réenregistrer des messages audio, le circuit étant constitué d'un microphone (44), d'un circuit de traitement de signal associé à l'audio (45), d'un haut-parleur (46), d'une source d'alimentation (41), d'un commutateur/bouton poussoir d'enregistrement (42) et d'un commutateur (48),
b. un boîtier constitué de deux parties, un corps (32) et un couvercle (31),
c. la partie de couvercle (31) du boîtier, conjointement avec le commutateur sous-jacent (48), est l'actionneur de la fonction de lecture,
d. des moyens de fixation modifiables (33) pour fixer le dispositif audio à différents objets et surfaces, lesquels moyens de fixation modifiables (33) sont conçus pour être pressionnés sur la partie de corps (32) du boîtier, de sorte que le bouton d'enregistrement (42), le microphone (44) et un mécanisme de changement de batterie sont cachés entre les moyens de fixation (33) et le corps (32) du boîtier et protégés par ceux-ci.

2. Système de production de messages audio réenregistrables, polyvalent, pour enregistrer et lire des informations audio comme décrit dans la revendication 1, dans lequel ledit circuit inclut des moyens (43) pour télécharger un nouveau message depuis une source externe en utilisant un signal électrique, RF ou IR.

3. Système de production de messages audio réenregistrables, polyvalent, pour enregistrer et lire des informations audio comme décrit dans la revendication 1, dans lequel ledit circuit inclut des moyens (49) pour lire le message lorsqu'une condition externe est remplie, la condition peut être détectée par un autre dispositif et indiquée au système de production de messages audio réenregistrables, polyvalent par signalisation en utilisant un signal électrique, RF ou IR.

4. Système de production de messages audio réenregistrables, polyvalent, pour enregistrer et lire des informations audio comme décrit dans la revendication 3, dans lequel ledit circuit inclut des moyens pour répondre à l'aide d'un message différent à des conditions externes différentes.

5. Système de production de messages audio réenregistrables, polyvalent, pour enregistrer et lire des informations audio comme décrit dans la revendication 1, dans lequel lesdits moyens de fixation (33) peuvent inclure une fonctionnalité qui permet d'utiliser les moyens de fixation (33) en tant que "station d'accueil" dans le système de production de messages audio réenregistrables, polyvalent, fournissant une connexion électrique, RF ou IR à un dispositif externe et une signalisation adéquate au système de production de messages audio réenregistrables, polyvalent.

6. Système de production de messages audio réenregistrables, polyvalent, pour enregistrer et lire les informations audio comme décrit dans la revendication 1, dans lequel ledit couvercle (31) a les fonctions suivantes :
a. il protège le circuit intégré dans la partie de corps du système de production de messages audio réenregistrables, polyvalent (32) du boîtier ;
b. il forme la cavité de résonance du haut-parleur (46) fixé à celui-ci.

7. Système de production de messages audio réenregistrables, polyvalent, pour enregistrer et lire des informations audio, comme décrit dans la revendication 1, dans lequel
a. le haut-parleur (46) est fixé sur le couvercle (31) du boîtier de sorte qu'il fonctionne via le haut du boîtier,
b. le microphone (44), le commutateur/bouton poussoir d'enregistrement (42) et/ou le mécanisme de changement de batterie sont fixés sur la partie de corps (32) du boîtier de sorte qu'ils sont accessibles depuis le dessous du boîtier.

8. Système de production de messages audio réenregistrables, polyvalent, pour enregistrer et lire des informations audio comme décrit dans la revendication 1, dans lequel une pression sur ledit couvercle (31) entraîne l'utilisateur à travers une séquence de messages.

9. Système de production de messages audio réenregistrables, polyvalent, pour enregistrer et lire des informations audio comme décrit dans la revendication 1, dans lequel ledit circuit inclut une minuterie pour changer le message délivré en fonction de l'heure du jour.
